# FASCICULE DE BREVET EUROPEEN

(11) **EP 1 264 299 B1**
(45) Date de publication et mention de la délivrance du brevet: **19.05.2004**
(21) Numéro de dépôt: 01913951.8
(22) Date de dépôt: 07.03.2001
(51) Int. Cl.: G09G 5/40, H03M 7/30

(54) **PROCEDE POUR LE CODAGE D'IMAGES**
VERFAHREN ZUR BILDKODIERUNG
IMAGE ENCODING METHOD

(30) Priorité: 09.03.2000 FR 0003020
(43) Date de publication de la demande: 11.12.2002
(73) Titulaire: Auteuil Participation et Conseil, 75016 Paris (FR)
(72) Inventeur: REMY, Maurice, F-75016 Paris (FR)
(74) Mandataire: Callon de Lamarck, Jean-Robert
(86) Numéro de dépôt international: PCT/FR2001/000681
(87) Numéro de publication internationale: WO 2001/067430

(56) Documents cités:
- EP-A- 0 953 901
- WO-A-94/10643
- US-A- 4 558 302
- US-A- 4 814 756

## Description

La présente invention est relative à un procédé pour le codage d'images.

Elle trouve notamment avantageusement application pour le codage d'images de taille limitée (largeur et hauteur de l'ordre de ou inférieures à 400 pixels, par exemple), et plus particulièrement pour le codage et la compression d'images simples à afficher sur des écrans de petite taille (écrans de téléphones portables ou de tout autre terminal portatif), telles que des images de publicité comportant des logos ou des caractères alphanumériques avec un graphisme particulier, ou encore des représentations stylisées (graphismes commerciaux, images du type de celles connues sous la dénomination "clipart").

On souhaite en effet, notamment pour les applications décrites dans la demande de brevet français de la demanderesse déposée sous le numéro FR-00.683, pouvoir transmettre et afficher des images du type précité sur des écrans de terminaux portatifs, tels que des téléphones portables ou encore des ordinateurs de poche du type de ceux commercialisés par la société 3COM sous la dénomination « Palm » ou du type de ceux utilisant le système d'exploitation Windows CE et commercialisés par les sociétés CASIO et COMPAQ sous les dénominations respectives « Cassiopeia » et « Aero ».

Un but de l'invention est donc de proposer un procédé pour le codage et la compression d'images permettant une grande fidélité graphique, et notamment un bon rendu des logos et du graphisme propres aux annonceurs et permettant en outre une transmission utilisant par image un nombre d'octets limité (400/500 octets utiles par image par exemple).

De nombreuses techniques de codage et compression sont déjà connues.

Un système de codage et compression proche des besoins exprimés est le "Bitmap Compuserve GIF" qui est notamment fortement utilisé sur Internet.

On pourra à cet égard se référer au brevet US 4 558 302 d'Unisys Corporation's « LZW (Lempel-Zev-Welch) compression and decompression methods ».

Ce système code les images avec 2, 3, 4, 8 bits par pixels suivant la nature de l'image.

Toutefois, il ne s'avère pas plus performant qu'un code statistique classique et est particulièrement peu efficace pour des images simples, pour lesquelles, compte tenu du niveau de rendu souhaité, il nécessite un traitement vectoriel.

### PRESENTATION DE L'INVENTION

La solution proposée par l'invention, qui s'avère nettement plus performante, est un procédé pour le codage d'une image numérisée comportant plusieurs lignes de pixels, selon lequel on code une ligne par une succession de sous-codes caractéristiques de la longueur des plages successives et de leur couleur,
caractérisé en ce que
- lorsque l'image comporte plusieurs lignes successives identiques, on code la première de ces lignes et on complète ce code par un sous-code caractéristique de la répétition de la ligne et du nombre de fois où la ligne est répétée à la suite de cette première ligne,
- lorsque l'image comporte plusieurs lignes comportant la même succession de couleurs, on code la première de ces lignes et on complète ce code par une succession de sous-codes caractéristique de la répétition de la succession de couleurs et de la longueur des différentes plages des différentes lignes.

Un tel procédé est avantageusement complété par les différentes caractéristiques suivantes prises seules ou selon toutes leurs combinaisons possibles :
- le code d'une ligne qui n'est pas identique à la ligne précédente ou qui ne comporte pas la même succession de couleurs comprend successivement pour chaque plage de couleur un sous-code caractéristique de la couleur de ladite plage et un sous-code caractéristique de la longueur de la plage ;
- une couleur est codée sur quinze valeurs ;
- si la longueur de la plage est inférieure à 15 pixels, la plage est codée sur un octet XY, où X est le numéro hexadécimal de la couleur et Y la longueur également en hexadécimal de la plage et si la longueur de la plage est supérieure à 15 pixels, la plage est codée sur deux octets X0, ZY où X est le numéro de la couleur de la plage et ZY la longueur de la plage ;
- lorsque l'image comporte plusieurs lignes successives identiques, si le nombre de lignes à reproduire identiques à la dernière ligne codée est inférieur à 15, le code de répétition est codé sur un octet ; et si ce nombre est supérieur à 15, le code de répétition se décompose en deux octets, l'un caractéristique de la fonction de répétition, l'autre qui code le nombre de lignes à reproduire ;
- lorsqu'une ligne possède la même structure de plages que la précédente, on code la longueur de ses plages de la façon suivante : si la longueur d'une plage est inférieure à 15 pixels, sa longueur est codée sur un demi-octet, et si la longueur d'une plage est supérieure à 15 pixels, sa longueur est codée sur trois demi-octets 0, ZY où ZY est la longueur de la plage ;
- on met en oeuvre un traitement de compression statistique sur l'image codée ;
- les images sont de dimensions largeur et hauteur de l'ordre de ou inférieures à 400 pixels et sont codées sur un nombre d'octets de l'ordre de ou inférieur à 500.

L'invention concerne également un procédé caractérisé en ce qu'on met en oeuvre le procédé de codage du type précité sur une pluralité d'images et en ce qu'on diffuse en boucle les images ainsi codées à destination d'au moins un terminal portatif qui décode les images codées qu'il reçoit pour les afficher sur son écran.

Elle concerne en outre un système de diffusion de données en boucle comportant des moyens pour la radio-diffusion de blocs de données dans une zone donnée, une pluralité de terminaux portatifs aptes à recevoir les blocs de données ainsi radio-diffusés, des moyens de traitement qui gèrent la diffusion desdites données, caractérisé en ce que lesdits moyens de traitement et lesdits terminaux portatifs mettent en oeuvre un procédé du type précité.

D'autres caractéristiques et avantages de l'invention ressortiront encore de la description qui suit, laquelle est purement illustrative et non limitative.

### DESCRIPTION D'AU MOINS UN MODE DE MISE EN OEUVRE DE L'INVENTION

Une première étape d'un mode de mise en oeuvre possible de l'invention consiste en un prétraitement de l'image qui vise à éliminer les couleurs intermédiaires attribuées aux pixels lors de la numérisation d'une image analogique et limite le nombre des couleurs à transmettre tout en améliorant l'aspect de l'image. Il peut être complété par une retouche manuelle limitée à quelques pixels.

On met ensuite en oeuvre un codage sur les lignes courantes de l'image, avec utilisation de la corrélation entre lignes successives pour réduire la taille du code.

Enfin, on met en oeuvre une compression statistique finale permettant d'exploiter la structure statistique de l'image.

### DESCRIPTION DU CODAGE

Le codage est réalisé sur quinze couleurs.

Le code utilisé pour décrire une image comporte deux parties, juxtaposées dans le fichier final, c'est à dire après compression :
- l'entête décrivant les caractéristiques générales de l'image codée (type de compression statistique, taille de l'entête, taille de l'image, palette de couleur),
- le code de l'image proprement dit qui permet de reconstituer la couleur de chacun des pixels, une fois l'entête connue.

### L'ENTETE

L'entête comprend un nombre d'octets variable dépendant du nombre de couleurs que comporte l'image à coder (15 au maximum).

Plus exactement, ce nombre d'octets est égal à 3 fois le nombre de couleurs à coder plus quatre.

L'affectation des divers octets de l'entête est donnée par le tableau 3.1, où Bᵢ désigne le ième octet.

**Tableau 3.1**

| **Rang de l'octet** | **Affectation** | **Plage/signification** |
|---|---|---|
| B₀ | Type de compression statistique et version | B₀=80+k (80 pour version 1.0) (82,83,84,88) |
| B₁ | données de décalage, rang du premier octet du code image | (7-46) |
| B₂ | Largeur de l'image (pixels) | (1-240) |
| B₃ | Hauteur de l'image (pixels) | (1-255) |
| B₄ à B₆ | RVB* de la couleur 0 | (1-255) |
| B₇ à B₉ | RVB de la couleur 1 | (1-255) |
| .... | ..... | .... |
| B_{3N+1} à B_{3(N+1)} | RVB de la couleur N | (1-255) |
| ..... | ..... | ..... |

| | | |
|---|---|---|
| * R, V et B sont les coordonnées colorimétriques rouge, vert et bleu de la couleur de la plage codées sur un octet selon les standards informatiques courants VGA, SVGA, XVGA et autres. | | |

### CODAGE DE L'IMAGE PROPREMENT DITE

Le codage de l'image s'effectue ligne par ligne ou par paquets de lignes identiques en commençant en haut à gauche de l'image et en terminant en bas à droite.

On utilise trois types de codage pour les lignes selon que :
- la ligne courante est identique à la précédente (codage de lignes répétitives),
- la ligne courante est semblable à la précédente en ce qu'elle comporte la même séquence de plages de couleurs, mais avec des longueurs de plages différentes (codage de lignes de même structure),
- la ligne courante est originale en ce sens qu'elle n'appartient pas aux deux catégories précédentes (codage standard d'une ligne).
   La première ligne d'une image est toujours codée en mode standard.

### CODAGE STANDARD D'UNE LIGNE

Le code donne successivement pour chaque plage de couleur de la ligne le numéro de la couleur codé de 0 à 14 (la valeur 15 est réservée pour les « drapeaux » repérant certaines fonctionnalités) et la longueur de la plage.
- si la longueur de la plage est inférieure à 15 pixels (même remarque que ci-dessus pour la valeur 15), la plage est codée XY hex. sur un octet où X est le numéro hexadécimal de la couleur et Y la longueur également en hexadécimal de la plage (X≤E, 1≤Y≤E), E représentant le nombre 14 en hexadécimal (E hex.=14 dec.) de même F hex.=15 dec. ;
- si la longueur de la plage est supérieure à 15 pixels, la plage est codée sur deux octets X0, ZY où X est le numéro de la couleur de la plage (X≤E) et ZY la longueur de la plage.

### CODAGE DE LIGNES REPETITIVES

Lorsque le codeur a détecté qu'une ligne est identique à celle qui la précède, ou qu'une suite de lignes est identique à la dernière ligne codée, il ne décrit pas les plages de ces lignes et se limite à envoyer un code de répétition.
- si le nombre de lignes à reproduire identiques à la dernière ligne codée est inférieur à 15, le code de répétition est un octet de la forme FW où W≤E est le nombre de lignes identiques à la précédente que le décodeur doit reproduire, FW étant le code de répétition associé à W ;
- si ce nombre est supérieur à 15, on utilise la même procédure d'échappement que pour le codage des plages ; le « drapeau» de répétition prend la forme F0 suivi d'un octet qui code le nombre de lignes à reproduire TW (01≤TW≤FE)

### CODAGE DE LIGNES DE MEME STRUCTURE

Si une ligne possède la même structure de plages que la précédente (même nombre, mêmes couleurs dans le même ordre), il n'est pas nécessaire de transmettre à nouveau les couleurs puisque l'on peut copier la structure sur la ligne précédente.

Le codage d'une ligne de cette nature est signalé par le « drapeau » FF ; les longueurs de plages sont codées de la manière suivante :
- si la longueur de la plage est inférieure à 15 pixels, la plage est codée Y sur un demi-octet (Y≤E),
- si la longueur de la plage est supérieure à 15 pixels, la plage est codée sur trois demi-octets 0, Z, Y où ZY est la longueur de la plage.

La suite des demi-octets est ensuite réassemblée en octets avec adjonction éventuelle d'un demi octet de bourrage à la fin de la ligne si le codage conduit à un nombre impair de demi-octets.

### COMPRESSION STATISTIQUE

Les codes correspondant aux différentes lignes sont assemblés séquentiellement pour donner le code de l'image complète.

Cependant, ce code ne tient pas compte de la statistique introduite par la structure de l'image. Le compresseur statistique a pour but d'exploiter au mieux cette répartition dans des conditions adaptées à la taille limitée du code.

Dans le principe retenu le code répartit les octets en deux classes :
- les octets les plus fréquents qui sont codés sur 2, 3 ou 4 bits précédés d'un bit mis à 0 soit respectivement des mots de 3,4 et 5 bits,
- les octets les moins fréquents sont transmis intégralement et précédés d'un bit mis à 1 soit 9 bits au total.

Le choix à effectuer entre les différentes solutions de compression est effectué par le codeur après avoir calculé la taille totale du code résultant. Celui-ci sélectionne le mode le plus efficace entre les quatre solutions possibles. Ce choix est inscrit dans le paramètre k accessible à partir du premier octet de l'entête (tableau 3.2). A priori la compression statistique n'est pas mise en oeuvre pour des tailles de code image avant compression inférieures à un seuil réglable (20 octets en valeur typique).

**Tableau 3.2**

| | |
|---|---|
| Pas de compression statistique | K=8 |
| Compression sur 2 bits | K=2 |
| Compression sur 3 bits | K=3 |
| Compression sur 4 bits | K=4 |

Les 2^{k} premiers octets du code image compressé constituent la table de correspondance entre le code réduit sur k bits et les octets compressés. Le premier octet étant codé 0, le suivant 1, le dernier 2^{k}-1 ([11], [111] ou [1111] en binaire).

La suite du code image compressé est construit comme suit :
1) on constitue une suite de mots de k+1 ou 9 bits représentant chacun l'un des octets du code avant compression selon la règle suivante :
   - si l'octet figure au tableau des octets les plus fréquents au rang n, il est codé par le mot binaire formé par 0 suivi par l'expression binaire sur k bits de n, (exemple l'octet au rang 5 parmi les 0, 1...7 octets du tableau (k=3) est codé [0101],
   - si l'octet ne figure pas à ce tableau, il est codé par le mot binaire formé par 1 suivi du code binaire inchangé de l'octet en question, (exemple l'octet 242 qui ne figure pas au tableau est codé [111110010]).
2) on procède ensuite au compactage en octets de la suite des mots ainsi constitués. Si la longueur totale de la chaîne de mots n'est pas un multiple de 8, on ajoute à la fin de la chaîne un mot de bourrage pour compléter à un multiple de 8 la chaîne. Ce mot de bourrage est formé d'un suivi d'autant de zéros qu'il est nécessaire. Dans la mesure où la longueur totale de ce mot est inférieure ou égale à 7 et où il débute par un 1 qui signale habituellement un mot de 9 bits, il est facilement reconnu et éliminé par le décodeur.

Le code final est alors assemblé en chaînant les composants suivants :
1) si k=8 (pas de compression statistique) chaînage de l'entête et du code image non compressé
2) si k=2, 3 ou 4, chaînage de l'entête, de la séquence des octets les plus fréquents et du code image compressé.

### AUTRES CARACTERISTIQUES

En cas d'erreurs conduisant à l'impossibilité de décoder l'image, le décodeur renvoie une image par défaut constituée d'un rectangle aux dimensions de l'image et dans la couleur « 0 », dans la mesure où il est capable de lire les premiers octets de l'entête.

Le procédé utilisé permet aussi la réalisation de transparences (« inlay ») en rendant le fond de l'image transparent. Pour réaliser une transparence, le codeur attribue aux plages transparentes un numéro de couleur immédiatement supérieur à la dernière couleur décrite dans l'entête. ceci conduit à réduire à 14 le nombre de couleurs réellement disponibles pour l'image.

On l'aura compris, le traitement de codage qui vient d'être décrit et celui de décodage sont dissymétriques, le codage nécessitant plus de puissance que le décodage, ce qui est particulièrement intéressant pour le type d'applications envisagées.

Le décodage mis en oeuvre par les moyens de traitement des terminaux portatifs est inverse du traitement de codage et permet une restitution de l'image sur un terminal équipé du logiciel Windows CE, pour des dimensions d'images du type de celles précédemment indiquées (images de 255 x 255 pixels, par exemple ou encore de 240x320 pixels).

Le traitement proposé permet non seulement le codage d'images comportant des logos ou des caractères alphanumériques avec un graphisme particulier, ou encore des représentations stylisées (graphismes commerciaux, images de type celles connues sous la dénomination "clipart").

Dans le cas d'images plus complexes, et notamment d'images de type photographique, on utilisera des solutions classiques (traitement "JPEG") avec fractionnement de l'image en tranches dont le codage requiert moins de 500 octets.

Le procédé de codage proposé trouve avantageusement application dans le cas d'images diffusées en boucle, le cas échéant avec d'autres éléments, à destination d'au moins un terminal portatif qui décode les images codées qu'il reçoit pour les afficher sur son écran.

En particulier, ce procédé de codage est avantageusement mis en oeuvre par les moyens de traitement d'un système de diffusion de données en boucle à destination de terminaux portatifs.

Un tel système est par exemple celui qui a été décrit dans la demande de brevet FR-00.683.

Il comporte notamment des moyens pour la radio-diffusion de blocs de données dans une zone donnée, une pluralité de terminaux portatifs aptes à recevoir les blocs de données ainsi radio-diffusés, des moyens de traitement qui gèrent la diffusion desdites données.

Lesdits terminaux portatifs sont alors porteurs d'un programme qui leur permet de décoder les images codées qu'il reçoit pour (le cas échéant) les afficher sur son écran.

## Revendications

1. Procédé pour le codage d'une image numérisée comportant plusieurs lignes de pixels, selon lequel on code une ligne par une succession de sous-codes caractéristiques de la longueur des plages successives et de leur couleur,
**caractérisé en ce que**
- lorsque l'image comporte plusieurs lignes successives identiques, on code la première de ces lignes et on complète ce code par un sous-code caractéristique de la répétition de la ligne et du nombre de fois où la ligne est répétée à la suite de cette première ligne,
- lorsque l'image comporte plusieurs lignes comportant la même succession de couleurs, on code la première de ces lignes et on complète ce code par une succession de sous-codes caractéristique de la répétition de la succession de couleurs et de la longueur des différentes plages des différentes lignes.

2. Procédé selon la revendication 1, **caractérisé en ce que** le code d'une ligne qui n'est pas identique à la ligne précédente ou qui ne comporte pas la même succession de couleurs comprend successivement pour chaque plage de couleur un sous-code caractéristique de la couleur de ladite plage et un sous-code caractéristique de la longueur de la plage.

3. Procédé selon la revendication 2, **caractérisé en ce qu'**une couleur est codée sur quinze valeurs.

4. Procédé selon l'une des revendications 2 et 3, **caractérisé en ce que**
- si la longueur de la plage est inférieure à 15 pixels, la plage est codée sur un octet XY, où X est le numéro hexadécimal de la couleur et Y la longueur également en hexadécimal de la plage,
- si la longueur de la plage est supérieure à 15 pixels, la plage est codée sur deux octets X0, ZY où X est le numéro de la couleur de la plage et ZY la longueur de la plage.

5. Procédé selon l'une des revendications précédentes, **caractérisé en ce que**, lorsque l'image comporte plusieurs lignes successives identiques,
- si le nombre de lignes à reproduire identiques à la dernière ligne codée est inférieur à 15, le code de répétition est codé sur un octet;
- si ce nombre est supérieur à 15, le code de répétition se décompose en deux octets, l'un caractéristique de la fonction de répétition, l'autre qui code le nombre de lignes à reproduire

6. Procédé selon l'une des revendications précédentes, **caractérisé en ce que** lorsqu'une ligne possède la même structure de plages que la précédente, on code la longueur de ses plages de la façon suivante :
- si la longueur d'une plage est inférieure à 15 pixels, sa longueur est codée sur un demi-octet,
- si la longueur d'une plage est supérieure à 15 pixels, sa longueur est codée sur trois demi-octets 0, ZY où ZY est la longueur de la plage.

7. Procédé selon l'une des revendications précédentes, **caractérisé en ce qu'**on met en oeuvre un traitement de compression statistique sur l'image codée.

8. Procédé selon l'une des revendications précédentes, **caractérisé en ce que** les images sont de dimensions largeur et hauteur de l'ordre de ou inférieures à 400 pixels et sont codées sur un nombre d'octets de l'ordre de ou inférieur à 500.

9. Procédé **caractérisé en ce qu'**on met en oeuvre le procédé de codage selon l'une des revendications précédentes sur une pluralité d'images et **en ce qu'**on diffuse en boucle les images ainsi codées à destination d'au moins un terminal portatif qui décode les images codées qu'il reçoit pour les afficher sur son écran.

10. Système de diffusion de données en boucle comportant des moyens pour la radio-diffusion de blocs de données dans une zone donnée, une pluralité de terminaux portatifs aptes à recevoir les blocs de données ainsi radio-diffusés, des moyens de traitement qui gèrent la diffusion desdites données, **caractérisé en ce que** lesdits moyens de traitement et lesdits terminaux portatifs mettent en oeuvre un procédé selon la revendication 9.

## Patentansprüche

1. Verfahren zum Codieren eines digitalisierten Bildes, das mehrere Pixelzeilen umfaßt, gemäß dem eine Zeile durch eine Folge von Untercodes codiert wird, die für die Länge der aufeinanderfolgenden Abschnitte und deren Farbe kennzeichnend ist,
**dadurch gekennzeichnet, daß**
- wenn das Bild mehrere aufeinanderfolgende identische Zeilen enthält, die erste dieser Zeilen codiert und dieser Code durch einen Untercode vervollständigt wird, der für die Wiederholung der Zeile und die Anzahl der auf diese erste Zeile folgenden Wiederholungen der Zeile kennzeichnend ist,
- wenn das Bild mehrere Zeilen enthält, die dieselbe Farbfolge aufweisen, die erste dieser Zeilen codiert wird und dieser Code durch eine Folge von Untercodes vervollständigt wird, die für die Wiederholung der Farbfolge und die Länge der verschiedenen Abschnitte der verschiedenen Linien kennzeichnend sind.

2. Verfahren nach Anspruch 1, **dadurch gekennzeichnet, daß** der Code einer Zeile, die nicht identisch mit der vorhergehenden Zeile ist oder die nicht dieselbe Farbfolge aufweist, aufeinanderfolgend für jeden Farbabschnitt einen Untercode, der für die Farbe des Abschnitts kennzeichnend ist, und einen Untercode, der für die Länge des Abschnitts kennzeichnend ist, umfaßt.

3. Verfahren nach Anspruch 2, **dadurch gekennzeichnet, daß** eine Farbe mit fünfzehn Werten codiert ist.

4. Verfahren nach Anspruch 2 oder 3, **dadurch gekennzeichnet, daß**
- wenn die Länge des Abschnitts unter 15 Pixel liegt, der Abschnitt mit einem Byte XY codiert wird, wobei X die Hexadezimalzahl der Farbe und Y ebenso in Hexadezimalform die Länge des Abschnitts ist,
- wenn die Länge des Abschnitts über 15 Pixel liegt, der Abschnitt mit zwei Bytes X0, ZY codiert wird, wobei X die Farbnummer des Abschnitts und ZY die Länge des Abschnitts ist.

5. Verfahren nach einem der vorhergehenden Ansprüche, **dadurch gekennzeichnet, daß** wenn das Bild mehrere aufeinanderfolgende identische Zeilen enthält,
- wenn die Anzahl der zu wiederholenden Zeilen, die identisch zur letzten codierten Zeile sind, kleiner als 15 ist, der Wiederholungscode mit einem Byte codiert ist;
- wenn diese Anzahl größer als 15 ist, der Wiederholungscode sich in zwei Bytes aufgliedert, wobei das eine kennzeichnend für die Wiederholungsfunktion ist und das andere die Anzahl der zu wiederholenden Zeilen codiert.

6. Verfahren nach einem der vorhergehenden Ansprüche, **dadurch gekennzeichnet, daß** wenn eine Zeile dieselbe Abschnittstruktur wie die vorhergehende aufweist, die Länge dieser Abschnitte in folgender Weise codiert wird:
- wenn die Länge eines Abschnitts unter 15 Pixel liegt, wird seine Länge mit einem Halbbyte codiert,
- wenn die Länge eines Abschnitts über 15 Pixel liegt, wird seine Länge mit drei Halbbytes 0, ZY codiert, wobei ZY die Länge des Abschnitts ist.

7. Verfahren nach einem der vorhergehenden Ansprüche, **dadurch gekennzeichnet, daß** auf das codierte Bild eine Behandlung durch eine statistische Kompression anwendet wird.

8. Verfahren nach einem der vorhergehenden Ansprüche, **dadurch gekennzeichnet, daß** die Bilder Breiten- und Höhenabmessungen in der Größenordnung von oder kleiner als 400 Pixel haben und mit einer Anzahl von Bytes in der Größenordnung von oder kleiner als 500 codiert werden.

9. Verfahren, **dadurch gekennzeichnet, daß** das Codierverfahren gemäß einem der vorhergehenden Ansprüche auf mehrere Bilder angewendet wird und daß die so codierten Bilder in einer Schleife an wenigstens ein tragbares Endgerät übertragen werden, das die von ihm empfangenen codierten Bilder decodiert, um sie auf seinem Bildschirm darzustellen.

10. System zur Übertragung von Daten in einer Schleife, das Mittel zur Funkübertragung von Datenblöcken in einem gegebenen Bereich, mehrere tragbare Endgeräte, die geeignet sind die so funk-übertragenen Datenblöcke zu empfangen, Mittel zum Bearbeiten, die die Übertragung der Daten verwalten, umfaßt, **dadurch gekennzeichnet, daß** die Bearbeitungsmittel und die tragbaren Endgeräte ein Verfahren gemäß Anspruch 9 einsetzen.

## Claims

1. Method for coding a digitized image comprising several lines of pixels, according to which method a line is coded by a succession of subcodes characteristic of the length of the successive fields and of their colour,
**characterized in that**
- when the image comprises several identical successive lines, the first of these lines is coded and this code is supplemented with a subcode characteristic of the repetition of the line and of the number of times that the line is repeated subsequent to this first line,
- when the image comprises several lines comprising the same succession of colours, the first of these lines is coded and this code is supplemented with a succession of subcodes which is characteristic of the repetition of the succession of colours and of the length of the various fields of the various lines.

2. Method according to Claim 1, **characterized in that** the code of a line which is not identical to the previous line or which does not comprise the same succession of colours comprises successively for each colour field a subcode characteristic of the colour of the said field and a subcode characteristic of the length of the field.

3. Method according to Claim 2, **characterized in that** a colour is coded on fifteen values.

4. Method according to either of Claims 2 and 3, **characterized in that**
- if the length of the field is less than 15 pixels, the field is coded on a byte XY, where X is the hexadecimal index number of the colour and Y the length likewise in hexadecimal of the field,
- if the length of the field is greater than 15 pixels, the field is coded on two bytes X0, ZY where X is the index number of the colour of the field and ZY the length of the field.

5. Method according to one of the preceding claims, **characterized in that**, when the image comprises several identical successive lines,
- if the number of lines to be reproduced which are identical to the last line coded is less than 15, the repetition code is coded on one byte;
- if this number is greater than 15, the repetition code is split into two bytes, one characteristic of the repetition function, the other which codes the number of lines to be reproduced.

6. Method according to one of the preceding claims, **characterized in that** when a line possesses the same structure of fields as the previous one, the length of its fields is coded in the following manner:
- if the length of a field is less than 15 pixels, its length is coded on a half-byte,
- if the length of a field is greater than 15 pixels, its length is coded on three half-bytes 0, ZY where ZY is the length of the field.

7. Method according to one of the preceding claims, **characterized in that** a statistical compression processing is implemented on the coded image.

8. Method according to one of the preceding claims, **characterized in that** the images are of width and height dimensions of the order of or less than 400 pixels and are coded on a number of bytes of the order of or less than 500.

9. Method **characterized in that** the coding method according to one of the preceding claims is implemented on a plurality of images and **in that** the images thus coded are broadcast in a loop to at least one handheld terminal which decodes the coded images which it receives so as to display them on its screen.

10. System for broadcasting data in a loop comprising means for the radio broadcasting of data blocks in a given zone, a plurality of handheld terminals able to receive the data blocks thus radiobroadcast, processing means which manage the broadcasting of the said data, **characterized in that** the said processing means and the said handheld terminals implement a method according to Claim 9.
